# EUROPEAN PATENT APPLICATION

(11) **EP 3 930 430 A1**
(43) Date of publication of application: **29.12.2021**
(21) Application number: 21171129.6
(22) Date of filing: 29.04.2021
(51) Int. Cl.: H05K 3/32

(54) **BONDING STRUCTURE OF ELECTRICAL CONTACT, BONDING METHOD OF ELECTRICAL CONTACT AND BATTERY MODULE**

(30) Priority: 24.06.2020 TW 109121656; 22.02.2021 TW 110106196
(71) Applicant: Simplo Technology Co., Ltd., Hukou Township, Hsinchu County 303 (TW)
(72) Inventor: WU, Yuwen, NO. 21, LANE 24, TA CHIH RD., MA KUNG CITY, PENG HU COUNTY (TW); WU, Shanghsien, 303 No.471, Sec. 2, Bade Rd., Hukou Township, Hsinchu County (TW); WANG, Chunyao, 303 No.471, Sec. 2, Bade Rd., Hukou Township, Hsinchu County (TW)
(74) Representative: von Bülow & Tamada

(57) **Abstract**

A bonding structure of an electrical contact, a bonding method of the electrical contact and a battery module are provided. The bonding structure of the electrical contact includes an electroconductive part and an electrode sheet welded to the electroconductive part. The electrode sheet is a first metal material, and the electroconductive part is a second metal material. A welding track is formed on an interface formed by combining the electrode sheet with the electroconductive part. The welding track is a mixture of the first metal material and the second metal material. The welding track substantially has no overlap. In addition, the welding track includes a moving path, and a lateral path of performing a wobble movement or an oscillation movement on lateral sides of the moving path.

## Description

### CROSS-REFERENCE TO RELATED APPLICATIONS

This application claims priority of No. 109121656 filed in Taiwan R.O.C. on 2020/6/24 and No. 110106196 filed in Taiwan R.O.C. on 2021/2/22 under 35 USC 119, the entire content of which is hereby incorporated by reference.

### BACKGROUND OF THE INVENTION

### Field of the Invention

This disclosure relates to a bonding structure of an electrical contact, a bonding method of the electrical contact and a battery module including the bonding structure of the electrical contact, and more particularly to a bonding structure of an electrical contact having two different materials, wherein the bonding structure has a continuous welding track.

### Description of the Related Art

According to the prior art, Taiwan Patent No. M285125 discloses a battery module, in which different materials of metallic conductive sheets are disposed between battery cells or circuit substrates, and the battery cells are bonded in parallel or in series by way of resistance welding or soldering welding to form a conductive battery device.

The resistance welding can be performed when different materials need to be welded in a penetrating manner. However, the defective rate thereof is high. For example, a sticky needle, empty welding and spot explosion may be formed, the welding speed is low, and the selections of the materials upon production are limited. For instance, when materials having different melting points are arranged, they may not be welded together. Regarding the soldering welding, the tin wire functions as the welding material for each welding spot, the tin resources and human resources are wasted, and the environment contamination is increased. Furthermore, the soldering operation has the low speed. When the production conditions are uncertain and the welding techniques and skills are not proficient, the artificial soldering quality issues (e.g., cold soldering, open soldering, tin bead, tin trash, tin ball and the like) cannot be completely solved and avoided. However, when the battery device is open-circuited due to the above-mentioned problems, the battery module carried by the user cannot work. If the battery device is short-circuited, then the safety of the battery module is significantly decreased.

In addition, a welding method, such as single spot laser welding, is disclosed in China Patent No. CN108140494A. Regarding the single spot laser welding, the non-contact type laser welding technique focuses the energy onto the metal surface, so that two metal layers having different materials are welded together through the single spot laser. However, the difference between the properties of the two metal materials to be welded causes the abnormal welding (e.g., the weak welding, the too-deep welding causing the breakdown of the conductive metal sheet, and the like). If the battery device is short-circuited, then the safety of the battery module is significantly decreased.

### BRIEF SUMMARY OF THE INVENTION

An objective according to an embodiment of this disclosure is to provide a bonding structure of an electrical contact capable of reducing the over-welding phenomenon in the bonding structure, and a method of manufacturing the bonding structure of the electrical contact. An objective of another embodiment is to provide a battery module including bonding structures of electrical contacts functioning as bonding structures between a battery device and a circuit carrier to reduce the over-welding phenomenon. An objective of still another embodiment is to provide a bonding structure of an electrical contact having a better stability; a method of manufacturing the bonding structure of the electrical contact; and a battery module including the bonding structure of the electrical contact.

According to an embodiment of this disclosure, a bonding structure of an electrical contact including an electroconductive part and an electrode sheet is provided. The electrode sheet is welded to the electroconductive part. The electrode sheet is a first metal material, and the electroconductive part is a second metal material. A welding track is formed on an interface between the electrode sheet and the electroconductive part, and the welding track is a mixture of the first metal material and the second metal material. The welding track substantially has no overlap. Also, the welding track includes a moving path; and a lateral path of performing a wobble movement or an oscillation movement on lateral sides of the moving path. In addition, a transverse cross section of the welding track has two or more than two welding regions.

In one embodiment, the moving path preferably has a UU-shaped, U-shaped, V-shaped, III-shaped, IIII-shaped, M-shaped, W-shaped, W-shaped, S-shaped or II-shaped pattern.

In one embodiment, a track length of the welding track is greater than 0.5 mm, and a width of the transverse cross section of each of the welding regions is greater than 0.3 mm.

In one embodiment, a tensile strength of a welding portion produced by the welding track is greater than 1 Kgf.

In one embodiment, the welding track is formed using a high-energy beam to irradiate the interface between the electrode sheet and the electroconductive part, so that the first metal material and the second metal material are mixed together. In one embodiment, the circuit carrier is a printing circuit board assembly, and the electroconductive part includes a solder layer and a copper foil.

According to an embodiment of this disclosure, a battery module is provided. The battery module includes: the bonding structure of the electrical contact, at least one battery device and a circuit carrier. The at least one battery device includes the bonding structure of the electrical contact, the bonding structure includes an electrode sheet, and the electrode sheet extends out of a body of the at least one battery device. The circuit carrier includes the bonding structure of the electrical contact. The bonding structure includes an electroconductive part. A normal direction of the transverse cross section is not perpendicular to an extending direction of the electrode sheet extending out of the at least one battery device. In one embodiment, a normal direction of the transverse cross section is preferably parallel to the extending direction of the electrode sheet extending out of the at least one battery device.

In one embodiment, the extending direction of the electrode sheet extending out of the at least one battery device is a lengthwise direction of a pattern of the moving path.

According to an embodiment of this disclosure, a method of manufacturing the bonding structure of the electrical contact is provided. The method includes steps of using a high-energy beam to irradiate the interface between the electrode sheet and the electroconductive part stacked together, so that the first metal material and the second metal material are mixed together; moving the high-energy beam along the moving path; and making the high-energy beam perform the wobble movement or the oscillation movement on the lateral sides of the moving path to form the lateral path and to form the welding track.

In one embodiment, the step of using the high-energy beam generated by a high-energy beam generating device includes steps of: controlling an energy range outputted from the high-energy beam generating device to have a power ranging from 70 to 100 W; and controlling a welding rate of a movement of the high-energy beam moving along the moving path to range from 70 to 90 mm/sec.

In summary, the bonding structure of the electrical contact according to an embodiment of this disclosure has a welding track, which is a mixture of the first metal material and the second metal material and substantially has no overlap, wherein a transverse cross section of the welding track has two or more than two welding regions, so that the damage to the bottommost portion of the circuit carrier can be decreased, and the welding strength between the first metal material and the second metal material can be improved. In one embodiment, the bonding structure of the electrical contact can be used in the battery module to function as the bonding structure between the battery device and the circuit carrier.

### BRIEF DESCRIPTION OF THE SEVERAL VIEWS OF THE DRAWINGS

FIG. 1 is an exploded view showing a battery module of an embodiment of this disclosure.
FIG. 2 is a plane view showing an internal partial structure of the battery module of the embodiment of FIG. 1.
FIG. 3 shows top views of bonding structures of embodiments of this disclosure.
FIG. 4 shows dimensions of parts of the bonding structures of embodiments (a), (d) and (c) of FIG. 3.
FIG. 5A is a schematic enlarged view showing a pattern of the welding track of the embodiment (a) of FIG. 3.
FIG. 5B is a schematic enlarged view showing a pattern of the welding track of an embodiment of this disclosure.
FIG. 6 is a cross-sectional view showing a metal bonding structure of an embodiment of this disclosure.
FIG. 7A is a top view showing an M-shaped welding track having lateral side wobble movements.
FIG. 7B is a top view showing welding tracks of spot welding of six helical points.
FIG. 7C is a top view showing an M-shaped welding track having lateral side wobble movements according to another embodiment.
FIG. 8A is a top view showing an M-shaped welding pattern having partial overlap portions.
FIG. 8B is a cross-sectional view showing the overlap portion of FIG. 8A.

### DETAILED DESCRIPTION OF THE INVENTION

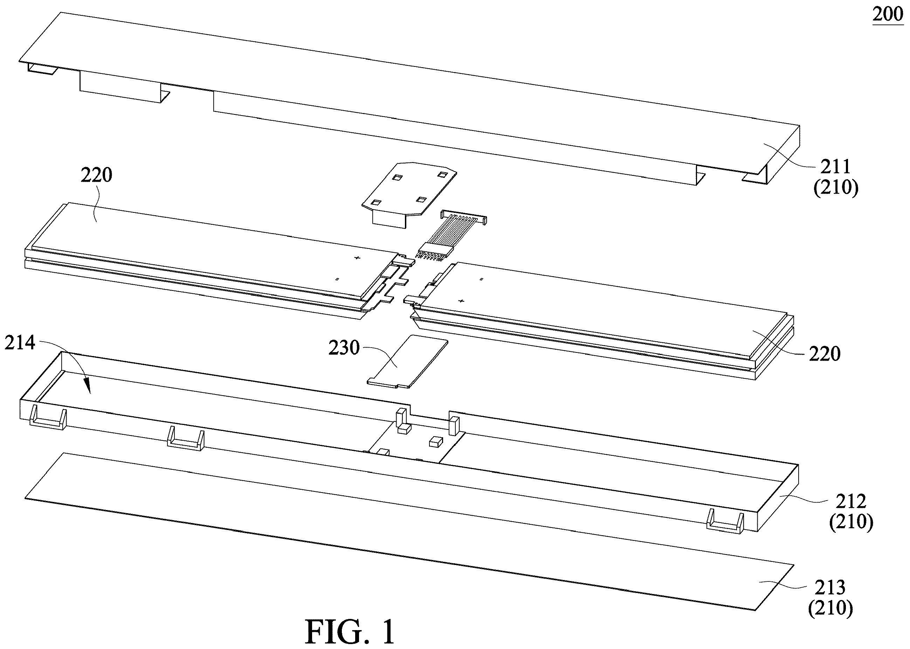

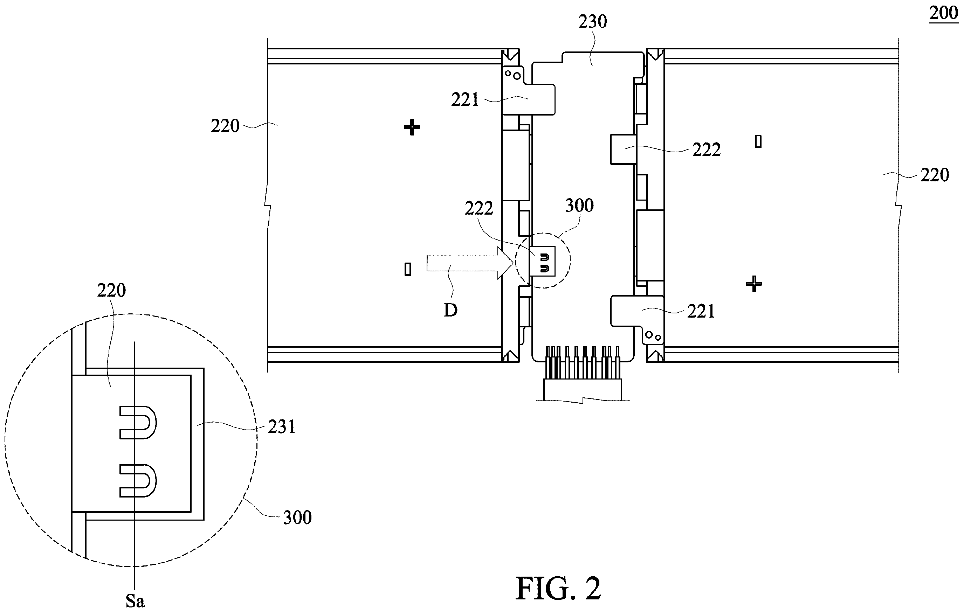

FIG. 1 is an exploded view showing a battery module of an embodiment of this disclosure. FIG. 2 is a plane view showing an internal partial structure of the battery module of the embodiment of FIG. 1. Referring to FIGS. 1 and 2, a battery module 200 according to an embodiment of this disclosure includes a housing 210, a bonding structure 300, at least one battery device 220 and a circuit carrier 230. The battery device 220 includes at least one battery cell. In one embodiment, there may be multiple battery cells, and each of the battery devices 220 has the battery cells connected in series and in parallel. The housing 210 defines a chamber 214 for accommodating the battery device 220 and the circuit carrier 230. As shown in FIG. 2, the battery device 220 is connected to the circuit carrier 230 through the bonding structure 300. The housing 210 includes a top cover 211, a bottom cover 213 and a frame 212. The frame 212 is disposed between the top cover 211 and the bottom cover 213, and defines the chamber 214.

FIG. 2 is a plane view showing an internal partial structure of the battery module of the embodiment of FIG. 1. Referring to FIG. 2, each battery device 220 includes a negative electrode sheet 222 and a positive electrode sheet 221, which are separated from each other and extend out of the body of the battery device 220. The negative electrode sheet 222 and the positive electrode sheet 221 are welded to multiple electroconductive parts 231 of the circuit carrier 230. In addition, bonding structures 300 are respectively formed between the negative electrode sheet 222 and an electroconductive part 231 of the circuit carrier 230, and between the positive electrode sheet 221 and another electroconductive part 231 of the circuit carrier 230, so that the battery devices 220 on the left side and the right side are electrically connected together, and the electric power of the battery device 220 is outputted to the external device through the circuit carrier 230.

According to this disclosure, the negative electrode sheet 222 and the positive electrode sheet 221 may have the same metal material or different metal materials. In one embodiment, when the battery device 220 is a lithium ion capacitor or a lithium ion secondary battery, and the negative electrode sheet 222 and the positive electrode sheet 221 have the same metal material, one of them dissolves due to the electrochemical action. Thus, the negative electrode sheet 222 and the positive electrode sheet 221 preferably include different metal materials. More specifically, the positive electrode sheet 221 contains aluminum and the negative electrode sheet 222 contains copper in this embodiment. The circuit carrier 230 may be a circuit board, a metal board and an acrylic board including circuits. The circuit board may be a printed circuit board (PCB) or a battery management system (BMS) control board.

In the bonding structure 300 of the negative electrode sheet 222 and the electroconductive part 231 of the circuit carrier 230, the negative electrode sheet 222 is a first metal material, and the electroconductive part 231 of the circuit carrier 230 is a second metal material. A welding track Lf (to be described later) is formed on an interface between the negative electrode sheet 222 and the electroconductive part 231 of the circuit carrier 230, wherein the welding track Lf is a mixture of the first metal material and the second metal material. An embodiment of this disclosure provides a bonding structure 300 including a first metal material and a second metal material, wherein a welding track Lf is formed on an interface between the first metal material and the second metal material. The first metal material and the second metal material may have the same material or different materials. Preferably, the material of the bonding structure 300 may be the combination material between pure metal sheets (e.g., copper nickel, nickel copper, copper copper, nickel nickel and the like); or may also be the welding material between a compound alloy (e.g., a metal alloy sheet including copper plated with nickel, iron plated with nickel or copper nickel alloy) and a nickel sheet, a silver-plated sheet, a gold-plated sheet, an electroless nickel immersion silver (ENIS) sheet, or an electroless nickel immersion Gold (ENIG) sheet.

In one embodiment, the bonding structure 300 is welded using a high-energy beam generated by a high-energy beam generating device (not shown). Preferably, laser welding is adopted. In one embodiment, the high-energy beam may be the irradiation light of an optical fiber laser device. In the high-power laser welding design, continuous welding by different welding methods is performed mainly using the high-power laser. The interface welding state of two independent metal sheets can be achieved according to the intensity of the laser energy, the movement rate, the shapes and dimensions of the to-be-welded object, and the material difference therebetween in conjunction with the precise fixture, so that the serial or parallel connection of the battery device 220 can be achieved. In one embodiment, the to-be-welded object may be the combination of two independent metal sheets (e.g., copper nickel, nickel copper, copper copper, nickel nickel and the like), may also be the welding material between a compound alloy (e.g., metal alloy sheet including copper plated with nickel, iron plated with nickel or copper nickel alloy) and a nickel sheet, a silver-plated sheet, a gold-plated sheet, an ENIS sheet, or an ENIG sheet. Preferably, the bonding structure 300 is used for the connection between the battery device 220 and the circuit substrate.

As shown in FIG. 2, the bonding structure 300 in one embodiment may be a bonding structure of the electrical contact, and may be used in a battery module 200, wherein the bonding structure 300 includes an electroconductive part and an electrode sheet. In this embodiment, the electroconductive part of the bonding structure 300 may be an electroconductive part 231 of the circuit carrier 230. However, this disclosure is not restricted thereto. In other embodiments, the electroconductive part of the bonding structure 300 may also be an electroconductive sheet, a bus, an electroconductive frame or a metal sheet. In this embodiment, the electrode sheet of the bonding structure 300 may be the positive electrode sheet 221 of the battery device 220, or the negative electrode sheet 222 of the battery device 220.

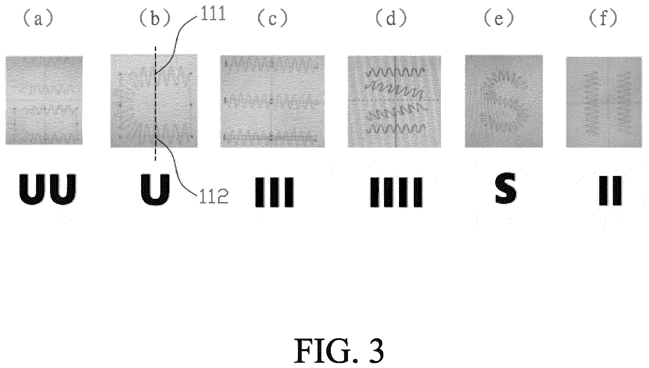

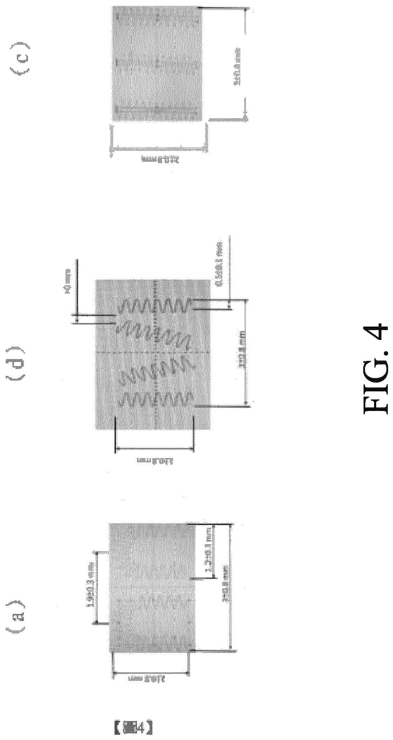

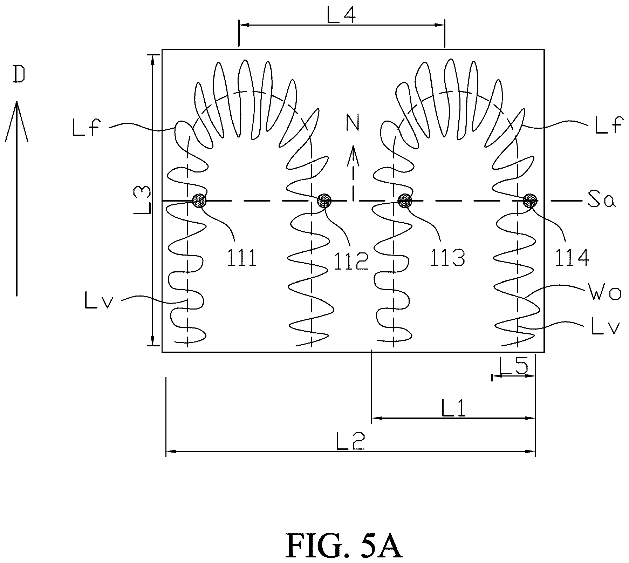

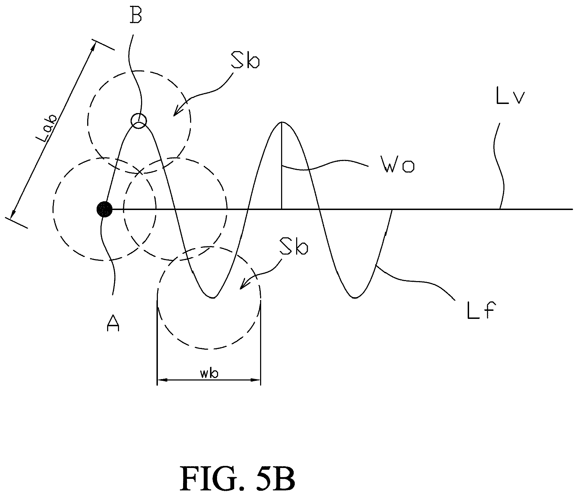

FIG. 3 shows top views of bonding structures 300 of embodiments of this disclosure. FIG. 4 shows dimensions of parts of the bonding structures 300 of embodiments (a), (d) and (c) of FIG. 3. FIG. 5A is a schematic enlarged view showing a pattern of the welding track of the embodiment (a) of FIG. 3. FIG. 5B is a schematic enlarged view showing a pattern of the welding track of an embodiment of this disclosure. FIG. 3 shows patterns of welding tracks Lf of the embodiments (a) to (f). As shown in embodiments (a) to (f) of FIG. 3, and FIGS. 5A and 5B, the welding track Lf substantially has no overlap, and the welding track Lf includes a moving path Lv, and a lateral path Wo which is formed by a wobble movement or an oscillation movement of a laser beam on the lateral sides of the moving path Lv. The moving paths Lv of the welding tracks Lf have UU-shaped, U-shaped, V-shaped, III-shaped, IIII-shaped (may be M-shaped, VV-shaped or W-shaped), S-shaped and II-shaped patterns. The laser track in the embodiment (d) of FIG. 3 is constituted by four straight lines which form multiple V-shaped paths, a M-shaped path or a W-shaped path, and the welding track Lf of the four straight lines substantially has no overlap.

As shown in FIG. 4, the line width of the pattern of the embodiment (d) of FIG. 4 is 0.5±0.1 mm. According to this disclosure, in the space of the effective welding region (6 mm * 4 mm) of the embodiments (a) to (f) of FIG. 3, the welding region has the dimension of about 3 mm * 2 mm (the dimension is finely tuned according to the requirement). The feature of the laser welding track pattern and the track length includes: the continuous laser welding track substantially has no overlap. In one embodiment, the continuous laser welding track is preferably a single independent track. In one embodiment, the effective welding region may be the electrode sheet with 7.8 mm * 4 mm; or the region of the electroconductive part, and the welding region with 3 mm * 2 mm is any region in the effective welding regions. In another embodiment, the effective welding region may be the overlap portion between the electrode sheet and the electroconductive part, and the welding region with 3 mm * 2 mm is any region in the effective welding regions.

In one embodiment, as shown in FIGS. 5A and 5B, the welding track Lf may be a continuous laser welding track. As shown in FIG. 5B, when the laser beam is not moved, the welding region Sb caused thereby is substantially circular, wherein the welding region Sb has the width wb. More specifically, the laser beam has the substantially circular shape, and irradiates the surface of the metal material to cause thermal diffusion to form the welding region Sb. When the laser beam is moved from the laser's center point A to the laser's center point B, for example, the welding track Lf forms a continuous line. In this disclosure, the welding track Lf formed by the laser's center point preferably has no overlap, and the thermal diffusion areas of the laser beam at different time instants are overlapped. In one embodiment, the track length of the welding track Lf is preferably greater than the width wb of the welding region Sb. For example, the distance Lab of the track length of the welding track Lf between the laser's center point A and the laser's center point B is greater than the width wb of the welding region Sb. When the length of the welding track Lf is smaller than the width wb of the welding region Sb, the laser beam is substantially not moved, and one single point is formed, so that the welding portion having the tensile strength greater than 1 Kgf cannot be formed. In one embodiment, the width wb of the welding region Sb is greater than or equal to 0.3 mm.

In one embodiment, the track length of the welding track Lf is preferably greater than (>) 0.5 mm. In one embodiment, a large portion (the best condition is the entire portion) of the transverse cross section Sa of the welding track Lf in the tensile test direction D (see FIGD. 2 and 5A) preferably has two or more than two welding regions 111 to 114, and the width of each of the welding regions 111 to 114 on the transverse cross section Sa is greater than or equal to 0.3 mm (the transverse cross section needs to be greater than or equal to two welding regions, and the width of the welding region on the transverse cross section Sa is greater than or equal to 0.3 mm). The so-called "a large portion" means more than one half. In addition, in one embodiment, when the welding regions 111 to 114 are just located on the diameter of the welding region Sb on the transverse cross section Sa, the width of each of the welding regions 111 to 114 on the transverse cross section Sa is substantially equal to the width wb of the welding region Sb. Preferably, as shown in the embodiment (b) of FIG. 3 and the embodiment of FIG. 5A, any transverse cross section Sa of the welding track Lf in the direction D has two or more than two welding regions 111 to 114. In the embodiment of FIG. 5A, any transverse cross section Sa of the welding track Lf in the direction D has four welding regions 111 to 114. In one embodiment, the tensile strength of the welding portion produced by the welding track Lf is preferably greater than 1 Kgf (the tensile strength needs to be greater than (>) 1 Kgf to satisfy the requirement). As shown in the embodiment (a) of FIG. 4, the width L1 on one single U-shaped pattern is equal to 1.2±0.3 mm, and the length L3 thereof is equal to 2±0.8 mm. The total width L2 of two U-shaped patterns is equal to 3±0.8 mm, and the distance L4 between the center lines of the two U-shaped patterns is equal to 1.9±0.3 mm. As shown in FIG. 5A, the double of the amplitude of the lateral path Wo or the distance L5 between two farthest terminals (which may be the line width of the moving path Lv of the welding track Lf in one embodiment) is equal to 0.5±0.1 mm.

As shown in FIGS. 2 and 5A, the tensile test direction D in one embodiment is the extending direction of the negative electrode sheet 222 or positive electrode sheet 221 extending out of the battery device 220. In one embodiment, the normal direction N of the transverse cross section Sa is not perpendicular to the tensile test direction D. Preferably, the direction normal N of the transverse cross section Sa is parallel to the tensile test direction D. In one embodiment, the tensile test direction D (the extending direction of the negative electrode sheet 222 or positive electrode sheet 221 extending out of the battery device 220) is the lengthwise direction of the welding pattern (U, I or S-shaped pattern). As shown in FIG. 2, the test direction D is the lengthwise direction of the U-shaped pattern. In one embodiment, the test direction D is substantially parallel to the extending direction of the long axis of the battery device. In one embodiment, the test direction D is substantially parallel to the extending direction of the electrode sheet projecting beyond the battery device 220. In one embodiment, the lengthwise direction of the welding pattern may be the extending direction of the pattern having the moving path Lv with the maximum length.

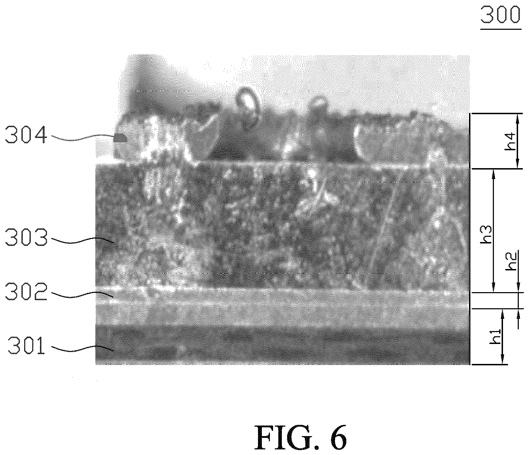

FIG. 6 is a cross-sectional view showing a metal bonding structure of an embodiment of this disclosure. The explanation and effect of the welding material are provided in the following. The materials of the electrode sheet and the electroconductive part in the bonding structure 300 of the electrical contact may be the same or different metals according to different product requirements, and are welded on a printing circuit board assembly (PCBA). As shown in FIG. 6, the bonding structure 300 includes a base 304, a substrate 303, a medium 302 and a carrier 301 stacked from top to bottom. The base 304 has a thickness h4 ranging from 0.05 to 0.25 mm. The material of the base may be nickel, copper, copper plated with nickel, a copper nickel alloy, iron plated with nickel or aluminum. The substrate 303 has a thickness h3 ranging from 0.1 to 0.6 mm. The material of the substrate may be nickel, copper, copper plated with nickel, a copper nickel alloy, an ENIG sheet and an ENIS sheet. The material of the medium may be solder tin, and the solder tin functioning as the medium 302 may have a thickness h2 ranging from 0.05 to 0.15 mm. The material of the carrier may be a PCB, a metal board, and an acrylic board. The carrier 301 may have a thickness h1 ranging from 0.5 to 1.5 mm.

Referring again to FIG. 5A, when the welding track Lf is composed of a moving path Lv along which a laser beam moves and a lateral path Wo formed by the wobble movement or oscillation movement of the laser beam on lateral sides of the moving path Lv. The moving path Lv determines the main shape of the pattern of the welding track Lf, while the lateral path Wo determines the line width of the pattern of the welding track Lf. It should be noted that this disclosure does not intend to restrict the main shape of the pattern, which may be linear or arced. The linear shape may be, for example, two straight lines, three straight lines or two straight lines together with two slant lines. The arced shape may be, for example, a double U shape, a single U shape or an S shape having the pattern in which the end points of the lines do not intersect with each other. More specifically, the main shape of the pattern of the welding track Lf may be the UU-shape, U-shape, III-shape, IIII-shape (preferably the M-shape or W-shape), S-shape, II-shape and the like. In one embodiment, the main shape is preferably the UU-shape, U-shape, M-shape or W-shape, S-shape and the like. The moving path Lv of these patterns includes not only the parallel lines, so the reliability is higher. In one embodiment, the moving path is preferably the UU-shape or U-shaped, so that the movement of the laser beam having the above shapes can be easily operated. The wobble movement or oscillation movement on the lateral sides of the moving path Lv can enlarge the welding area, and thus increase the tensile strength. In addition, because the laser beam is moved in the forwarding direction and lateral direction of the moving path Lv, the heat accumulation can be decreased to prevent the over-welding.

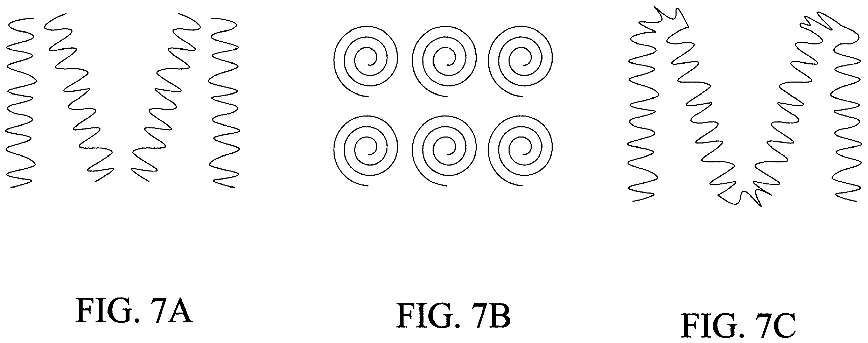

FIG. 7A is a top view showing an M-shaped welding track having lateral side wobble movements. FIG. 7B is a top view showing welding tracks of spot welding of six helical points. In the bonding structure 300, the pattern of the welding track Lf sometimes causes the too-high temperature to cause the tin melting phenomenon, so that the substrate is detached and the defective product is formed. A thermocouple temperature recorder is used to measure the highest welding temperature at the welding seam of the welding track Lf. The M-shaped welding pattern of FIG. 7A has the highest temperature of 82.9 °C. The welding patterns of six helical points of FIG. 7B have the highest temperature of 247.8 °C. Because the gap between the tracks of the welding pattern of the helical points is smaller, the higher temperature is caused. The welding pattern of the helical point is continuously welded from inside to outside using the helical pattern, and achieves the desired single-spot dimension, wherein the tracks are dense. So, the heat accumulation phenomenon occurs at the predetermined position to cause the too-high temperature. FIG. 7C is a top view showing an M-shaped welding track having lateral side wobble movements according to another embodiment. The embodiment of FIG. 7C is similar to the embodiment of FIG. 7A except for the difference that the four welding tracks of FIG. 7A are discontinuous, while the four welding tracks of FIG. 7C form a continuous welding track. As shown in FIG. 7C, the welding track Lf may also be continuous as long as no overlap is substantially present to cause the over-welding.

In one embodiment, the copper material is a high reflective material and has the lower absorptivity to the laser. So, the higher energy is needed to penetrate through the copper and the other metal to perform the welding operation. However, because the copper has the good thermal conductivity, the heat conduction tends to affect the solder of the lower layer of the to-be-welded object. In one embodiment, when the temperature exceeds 230 °C, the bottom solder layer is melted to generate the tin beads and tin trashes which damage the stability of the welding portion and cause the abnormal electrical property. The welding pattern of FIG. 7B has the highest temperature of 247.8 °C, so the welding stability is poor and the electrical property is abnormal. Compared with this, in this disclosure, different welding patterns is used to obtain the feature of different surface temperatures, so as to achieve the effect of controlling the welding strength between two metal materials without damaging the bottommost portion of solder layer and the copper foil of PCBA.

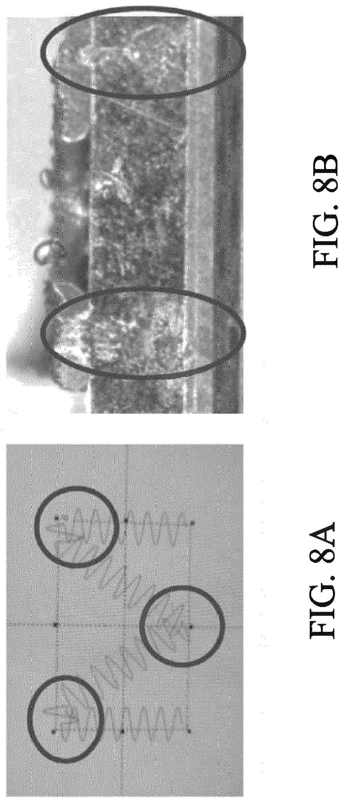

FIG. 8A is a top view showing an M-shaped welding pattern having partial overlap portions. The circled portions in FIG. 8A represent the overlapped portions. More specifically, in addition to the thermal diffusion area, the center points of the laser beams also have overlap portions. FIG. 8B is a cross-sectional view showing the overlap portion of FIG. 8A. As shown in FIG. 8B, the welding track Lf has the overlapped paths, the same point tends to be over-welded to cause the too-high temperature and the too-deep melting depth to encounter the melting-through phenomenon, thereby resulting in the damage of the lower copper foil and the poor electrical property thereof. If the positive electrode sheet or negative electrode sheet of the cylinder type battery is directly welded to the electroconductive part, the melting-through phenomenon may even cause the dangerous breakdown. Compared with this, in the embodiments of this disclosure, as shown in FIGS. 7A and 7C, the welding track Lf substantially has no overlap, and the path of the welding track Lf is independent, so that the effect of controlling the welding strength between two metal materials can be achieved without damaging the bottommost portion of solder layer and the copper foil of PCBA.

In the bonding structure 300, the number of the effective welding regions and the diameters of the welding areas on the transverse cross sections of the welding patterns affect the welding strength. So, when the number of the welding regions is smaller than 2, the tensile strength may be insufficient which is the causes of the phenomena including the abnormal detachment and the unstable process ability.

### [Tensile test]

In the following, different ratios of metal materials (0.15 copper and 0.4 nickel) and (0.1 copper and 0.4 nickel) are used to form different bonding structures 300 according to different patterns of welding tracks Lf, and tensile tests are performed on the bonding structures 300. More specifically, the comparative example 1 is the six-point pattern of FIG. 7B, the example 1 is the II pattern of the embodiment (f) of FIG. 3, the example 2 is the S pattern of the embodiment (e) of FIG. 3, the example 3 is the UU pattern of the embodiment (a) of FIG. 3, and each of the examples 1 to 3 or the comparative example 1 has the metal ratio of (0.15 copper: 0.4 nickel). In addition, the example 4 is the II pattern of the embodiment (f) of FIG. 3, the example 5 is the III pattern of the embodiment (c) of FIG. 3, the example 6 is the IIII pattern of the embodiment (d) of FIG. 3, the example 7 is the UU pattern of the embodiment (a) of FIG. 3, and each of the examples 4 to 7 has the metal ratio of (0.1 copper: 0.4 nickel). Meanwhile, the test results are listed in Table 1.

**Table 1: test result**

| | 0.15 copper and 0.4 nickel | | | |
|---|---|---|---|---|
| Parameter content | Comparative example 1 test value (Kgf) | Example 1 test value (Kgf) | Example 2 test value (Kgf) | Example 3 test value (Kgf) |
| MAX | 2.3 | 7.8 | 4.77 | 5.28 |
| MIN | 0.8 | 2.86 | 2.68 | 3.77 |
| AVERAGE | 1.47 | 5.02 | 3.71 | 4.58 |
| CPK | 0.48 | 0.767 | 2.1 | 2.7 |

| | 0.1 copper and 0.4 nickel | | | |
|---|---|---|---|---|
| Parameter content | Example 4 test value (Kgf) | Example 5 test value (Kgf) | Example 6 test value (Kgf) | Example 7 test value (Kgf) |
| MAX | 2.21 | 3.07 | 3.78 | 3.28 |
| MIN | 1.85 | 2.59 | 3.17 | 2.82 |
| AVERAGE | 2.05 | 2.82 | 3.49 | 4.54 |
| CPK | 2.99 | 5.62 | 6.3 | 6.62 |

As listed in Table 1, a minimum one of the tensile test results of the welding patterns of the six helical points shown in FIG. 7B is smaller than 1 Kgf. So, the welding stability is poor. Compared with this, each of the tensile test results of the welding patterns of the examples of Table 1 of this disclosure has a value greater than 1 Kgf. In one embodiment, the value of the tensile test is greater than 1.85, 2.21, 2.59, 2.68, 2.82, 2.86, 3.07, 3.17, 3.28, 3.77, 3.78, 4.77, 5.28 or 7.8 or fall within the ranges between any two of those numbers. In addition, CPK in Table 1 denotes the process ability indicator, wherein the higher value represents the stabler property.

According to an embodiment of this disclosure, a method of manufacturing the bonding structure 300 of the electrical contact is provided. The method includes the following steps.

In a step S02, a high-energy beam is used to irradiate an interface formed by an electrode sheet and an electroconductive part stacked together. In one embodiment, the interface may be formed by staking the negative electrode sheet 222 and the electroconductive part 231 of the circuit carrier 230 together, so that the first metal material of the negative electrode sheet 222 and the second metal material of the electroconductive part 231 of the circuit carrier 230 are mixed together to form a material mixture portion.

In a step S04, the high-energy beam is moved along the moving path Lv.

In a step S06, the high-energy beam performs the wobble movement or oscillation movement on the lateral sides of the moving path Lv to form the lateral path Wo so that the welding track Lf is formed.

In one embodiment, the step S02 of using the high-energy beam generated by a high-energy beam generating device includes the following steps. In a step S20, the energy range outputted from the high-energy beam generating device is controlled to have a power ranging from 70 to 100 W; and in a step S40, the welding rate of the movement of the high-energy beam moving along the moving path Lv is controlled to range from 70 to 90 mm/sec. In addition, the power of the energy required at any unit time on the path is constant, and may vary as the material is changed. So, when the power of the energy range gets higher, the moving speed for welding gets higher; and when the power of the energy range gets lower, the moving speed for welding gets lower.

In summary, the bonding structure of the electrical contact according to an embodiment of this disclosure has a welding track, and no overlap is formed on a path of the welding track. So, the welding strength between the first metal material and the second metal material can be improved without damaging the bottommost portion of the circuit carrier. In one embodiment, the bonding structure of the electrical contact can be used in the battery module to function as the bonding structure between the battery device and the circuit carrier. In one embodiment, a transverse cross section of the welding track has two or more than two welding regions. Preferably, the width of the welding regions on the transverse cross section is greater than 0.3 mm to satisfy the tensile test requirement and to reduce the number of occurrences of the situation that the welding stability is poor. In one embodiment, the circuit carrier is the PCBA copper foil, and the welding strength between the two metal materials can be improved without damaging the solder layer of the bottommost portion of the circuit carrier and the PCBA copper foil.

## Claims

1. A bonding structure of an electrical contact, comprising:
an electroconductive part; and
an electrode sheet welded to the electroconductive part, wherein:
the electrode sheet is a first metal material, and the electroconductive part is a second metal material;
a welding track is formed on an interface formed by combining the electrode sheet with the electroconductive part, and the welding track is a mixture of the first metal material and the second metal material;
the welding track substantially has no overlap;
the welding track comprises a moving path and a lateral path of performing a wobble movement or an oscillation movement on lateral sides of the moving path; and
a transverse cross section of the welding track has two or more than two welding regions.

2. The bonding structure of the of electrical contact according to claim 1, wherein the moving path has a UU-shaped, U-shaped, V-shaped, III-shaped, IIII-shaped, M-shaped, W-shaped, W-shaped, S-shaped or II-shaped pattern.

3. The bonding structure of the of electrical contact according to claim 1, wherein
a track length of the welding track is greater than 0.5 mm; and
a width of the welding regions on the transverse cross section is greater than 0.3 mm.

4. The bonding structure of the of electrical contact according to claim 2, wherein
a track length of the welding track is greater than 0.5 mm; and
a width of the welding regions on the transverse cross section is greater than 0.3 mm.

5. The bonding structure of the of electrical contact according to claim 1, wherein a tensile strength of a welding portion produced by the welding track is greater than 1 Kgf.

6. The bonding structure of the of electrical contact according to claim 2, wherein a tensile strength of a welding portion produced by the welding track is greater than 1 Kgf.

7. The bonding structure of the of electrical contact according to claim 3, wherein a tensile strength of a welding portion produced by the welding track is greater than 1 Kgf.

8. The bonding structure of the of electrical contact according to claim 1, wherein the welding track is formed using a high-energy beam to irradiate the interface, so that the first metal material and the second metal material are mixed together.

9. A battery module, comprising:
a bonding structure of the electrical contact according to claim 1;
at least one battery device comprising the electrode sheet of the bonding structure of the electrical contact, wherein the electrode sheet extends out of a body of the at least one battery device; and
a circuit carrier comprising the electroconductive part of the bonding structure of the electrical contact, wherein:
a normal direction of the transverse cross section is not perpendicular to an extending direction of the electrode sheet extending out of the at least one battery device.

10. The battery module according to claim 9, wherein the normal direction of the transverse cross section is parallel to the extending direction of the electrode sheet extending out of the at least one battery device.

11. The battery module according to claim 9, wherein the extending direction of the electrode sheet extending out of the at least one battery device is a lengthwise direction of a pattern of the moving path.

12. A method of manufacturing the bonding structure of the electrical contact according to claim 1, comprising steps of:
using a high-energy beam to irradiate the interface formed by combining the electrode sheet with the electroconductive part, so that the first metal material and the second metal material are mixed together;
moving the high-energy beam along the moving path; and
making the high-energy beam perform the wobble movement or the oscillation movement on the lateral sides of the moving path to form the lateral path and to form the welding track.

13. The method according to claim 12, wherein the step of using the high-energy beam to irradiate the interface between the electrode sheet and the electroconductive part stacked together comprises:
using a high-energy beam generating device to generate the high-energy beam;
controlling an energy range outputted from the high-energy beam generating device to have a power ranging from 70 to 100 W; and
controlling a welding rate of a movement of the high-energy beam moving along the moving path to range from 70 to 90 mm/sec.
